# EUROPEAN PATENT APPLICATION

(11) **EP 4 510 193 A1**
(43) Date of publication of application: **19.02.2025**
(21) Application number: 24189195.1
(22) Date of filing: 17.07.2024
(51) Int. Cl.: H01L 29/08, H01L 23/48, H01L 29/10, H01L 29/16, H01L 29/40, H01L 29/66, H01L 29/808

(54) **LATERAL SILICON CARBIDE JUNCTION GATE FIELD EFFECT TRANSISTOR DEVICE AND ITS MANUFACTURING METHOD**

(30) Priority: 15.08.2023 CN 202311020423
(71) Applicant: Suzhou Watech Electronics Co., Ltd., Suzhou, Jiangsu 215125 (CN)
(72) Inventor: WANG, Changchang, Suzhou, Jiangsu, 215125 (CN)
(74) Representative: Michalski Hüttermann & Partner Patentanwälte mbB

(57) **Abstract**

The embodiment of the present disclosure provided a lateral silicon carbide junction gate field effect transistor (SiC-JFET) device and a manufacturing method thereof. The lateral SiC-JFET device includes a base; a source and a drift region formed on the base in sequence; a first source contact region, a second source contact region, and a channel region formed on the source in sequence; and a gate formed on the channel region; where the channel region and the drift region are independent structures respectively.

## Description

### TECHNICAL FIELD

The present disclosure relates to the technical field of semiconductor devices, and more particularly to a lateral silicon carbide junction gate field effect (SiC-JFET) device and a manufacturing method thereof.

### BACKGROUND

As the third-generation semiconductor material, silicon carbide (SiC) has many advantages over the traditional silicon (Si) material. Firstly, SiC is a band gap material, the band gap of SiC reaches 3.2 eV, much higher than the band gap of Si (1.1 eV). Therefore, devices made with SiC are much smaller than devices made with Si under the same breakdown voltage, and generally, the size of devices can be reduced by more than ten times. Secondly, the carriers' mobility of SiC is close to Si, the electron saturation drift velocity of SiC is twice as fast as the electron saturation drift velocity of Si, and devices made with SiC are much smaller than devices made with Si under the same breakdown voltage. Therefore, it is easy to make a power device with SiC material having a small size, high breakdown voltage, and low conducting resistance, which makes devices with SiC material widely applied in power device fields. Moreover, SiC material has good thermal conductivity, for power applications, high-power applications can be supported by excellent thermal conductivity.

The conventional SiC power devices comprise SiC-based vertical double-diffused metal-oxide-semiconductor (VDMOS), vertical JFET (V-JFET), laterally diffused metal-oxide-semiconductor (LDMOS), and lateral JFET (L-JFET). For most radio frequency applications, the source general needs to be on the backside of the wafer to satisfy the heat dissipation and grounding requirements, so the mainstream radio frequency power devices are in the lateral structures. However, SiC-LDMOS has a problem with channel region mobility and reliability. Although the electron mobility of SiC is close to Si, the mobility generally refers to the body mobility of the material. For LDMOS devices being conducted, the carriers mainly move near the SiC-SiO2 interface in the channel, and the channel mobility here is affected by the SiC-SiO2 interface traps, so that the channel mobility of the SiC-LDMOS is low, and the impedance of the channel region is high. To improve the channel mobility, one of the common methods is to increase the gate voltage, so that a thicker inversion layer is formed under the channel, which reduces the effects of the SiC-SiO2 interface traps in the conduction portion of the channel. However, a too-high gate voltage will cause a gate oxide reliability problem.

The lateral SiC-JFET device can completely avoid the problem of channel mobility, the conduction portion of which is entirely within the SiC, so that the advantages of the SiC material can be fully functional.

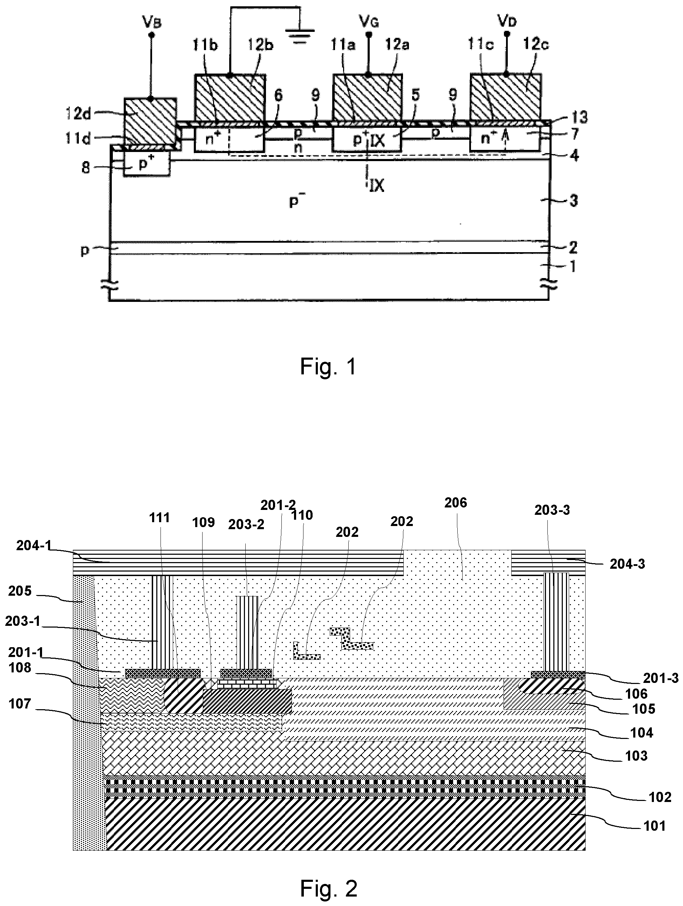

Fig. 1 is a structure diagram of an existing L-JFET. As shown in Fig. 1, references are substrate 1, first p-type epitaxial layer 2, p- epitaxial layer 3, n-type epitaxial layer 4, p gate region 5, n source region 6, n drain region 7, p+ impurities region 8, second p-type epitaxial layer 9, ohmic contact electrodes 11a, 11b,11c,11d, gate electrode 12a, source electrode 12b, drain electrode 12c, control electrode 12d, and oxide layer 13. The channel region of this structure is below the region of the gate electrode 12a, and the n drain region 7 relies on the reverse bias of the reverse PN junction formed by the portion between the gate electrode 12a to the n drain region 7 in the n-type epitaxial layer 4 and the p-epitaxial layer 3 for voltage bearing. As can be seen, the size regulation of the portion between the gate electrode 12a to the n drain region 7 in the n-type epitaxial layer 4 (i.e., the junction depth of the aforementioned PN junction) is limited by the channel region. Predictably, it is difficult to flexibly adjust the breakdown voltage for this device.

Therefore, the adjustment of breakdown voltage for the conventional lateral SiC-JFET device is limited by the size of the channel region, which is a technical problem that needs to be solved urgently by one having ordinary skills in the art.

The above information disclosed in the background is only for enhancing the understanding of the background of the present disclosure and thus may contain information that does not form the relevant art known to one having ordinary skills in the art.

### SUMMARY

The present disclosure provides a lateral silicon carbide junction gate field effect transistor (SiC-JFET) device and a manufacturing method thereof to solve the technical problem that the adjustment of breakdown voltage of the conventional lateral SiC-JFET device is limited by the size of the channel region.

According to the first aspect of the embodiment of the disclosure, a lateral SiC-JFET device is provided and comprises:
a base;
a source and a drift region formed on the base in sequence;
a first source contact region, a second source contact region, and a channel region formed on the source in sequence; and
a gate, formed on the channel region;
where the channel region and the drift region are independent structures respectively.

According to a second aspect of the embodiment of the disclosure, a manufacturing method of the lateral SiC-JFET device is provided, and comprises:
step S1: forming a base;
step S2: forming a source and a first source contact region on the base; and
step S3: forming a second source contact region, a channel region, a gate, and a drift region by implanting;
where the channel region and the drift region are respectively formed to be independent structures by respective independent implantation processes, so that the on-off characteristics of the lateral SiC-JFET device can be adjusted by the channel region separately and the breakdown voltage of the lateral SiC-JFET device can be adjusted by the drift region separately.

The embodiments of the present disclosure have the following technical advantages with the above technical proposals:

The channel region and the drift region are independent structures so the channel region and the drift region can be adjusted separately. The on-off of the lateral SiC-JFET device is controlled by turning off or turning on the channel region by a voltage variation between the source and the gate. The on-off characteristics of the device can be optimized separately by adjusting the implantation dose in the channel region separately. The bearing voltage of the lateral SiC-JFET device is realized by the reverse bias of the PN junction formed by the drift region and the epitaxial layers, and the breakdown voltage of the reverse bias of the PN junction formed by the drift region and the epitaxial layer is related to the sizes and the concentrations of the drift region and the epitaxial layer. Therefore, the breakdown voltage of the device can be flexibly adjusted by separately adjusting parameters such as the size and the implanting concentration of the drift region, and designs from tens to hundreds of volts of the breakdown voltage can be easily realized without being limited by the channel region.

### BRIEF DESCRIPTION OF THE DRAWINGS

The drawings described herein are intended to provide a further understanding of the present disclosure and are incorporated in and constitute a part of this specification, schematic embodiments of the disclosure together with the description serve to explain the principles of the present disclosure, and do not constitute an improper limitation of the present disclosure. In the drawings:
Fig. 1 is a structure diagram of a conventional L-JFET.
Fig. 2 is a schematic diagram of a lateral SiC-JFET device according to the embodiment of the present disclosure.
Fig. 3 is a schematic diagram of step S1 of a manufacturing method of a lateral SiC-JFET device according to the embodiment of the present disclosure.
Fig. 4 is a schematic diagram of step S2 of the manufacturing method of the lateral SiC-JFET device according to the embodiment of the present disclosure.
Fig. 5 is a schematic diagram of step S3 of the manufacturing method of the lateral SiC-JFET device according to the embodiment of the present disclosure.
Fig. 6 is a schematic diagram of step S4 of the manufacturing method of the lateral SiC-JFET device according to the embodiment of the present disclosure.
Fig. 7 is a schematic diagram of step S5 of the manufacturing method of the lateral SiC-JFET device according to the embodiment of the present disclosure.

### REFERENCES IN THE DRAWINGS:

In the background:
substrate 1, first p-type epitaxial layer 2, p- epitaxial layer 3, n-type epitaxial layer 4, p gate region 5, n source region 6, n drain region 7, p+ impurities region 8, second p-type epitaxial layer 9, ohmic contact electrodes 11a, 11b,11c,11d, gate electrode 12a, source electrode 12b, drain electrode 12c, control electrode 12d, and oxide layer13.

In the present disclosure:
substrate 101, P+ epitaxial layer 102, P- epitaxial layer 103, drift region 104, drain implant region 105, drain 106;
source 107, first source contact region 108, channel region 109, gate 110, second source contact region 111;
oxide layer 206;
source contact metallic compound 201-1, gate contact metallic compound 201-2, drain contact metallic compound 201-3;
gate shielding plate 202;
source contact through hole 203-1, gate contact through hole 203-2, drain contact through hole 203-3;
source metal layer 204-1, drain metal layer 204-3; and
grounded back hole 205.

### DETAILED DESCRIPTION OF THE EMBODIMENTS

In order to make technical solutions and advantages of embodiments of the disclosure clearer, exemplary embodiments of the disclosure are described in further detail below in combination with accompanying drawings. Obviously, the described embodiments are only part of the embodiments of the disclosure, not an exhaustive list of all embodiments. It should be noted that the embodiments of the disclosure and features in the embodiments may be combined with each other without conflicts.

### Embodiment 1

As shown in Fig. 2, the embodiment of the present disclosure provides a lateral SiC-JFET device, comprising:
a substrate 101, where the substrate 101 is N+ substrate;
a P+ epitaxial layer 102 disposed on the substrate 101;
a P- epitaxial layer 103 disposed on the P+ epitaxial layer 102;
a source 107 and a drift region 104 disposed inside the P- epitaxial layer 103 in sequence;
a first source contact region 108, a second source contact region 111, and a channel region 109 disposed on the source 107 in sequence; and
a gate 110, formed on the channel region 109;
where the channel region and the drift region are respectively formed to be independent structures by respective independent implantation processes, so that the on-off characteristics of the lateral SiC-JFET device can be adjusted by the channel region separately and the breakdown voltage of the lateral SiC-JFET device can be adjusted by the drift region separately.

In the lateral SiC-JFET device of the embodiments of the present disclosure, the channel region 109 and the drift region 104 are respectively formed to be independent structures by respective independent implantation processes, so that the channel region 109 and the drift region 104 can be adjusted separately. The on-off of the lateral SiC-JFET device is controlled by turning off or turning on the channel region by a voltage change between the source 107 and the gate 110. The on-off characteristics of the lateral SiC-JFET device can be optimized separately by adjusting the implantation dose in the channel region separately. The bearing voltage of the lateral SiC-JFET device is realized by the reverse bias of the PN junction formed by the drift region 104 and the epitaxial layers 103, whereas the breakdown voltage of the reverse bias of the PN junction formed by the drift region 104 and the epitaxial layers is related to the size and concentration of the drift region 104 and the epitaxial layers 103. Therefore, the breakdown voltage of the lateral SiC-JFET device can be flexibly adjusted by separately adjusting parameters such as the size of the drift region 104 and the implanting concentration, and designs from tens of volts to hundreds of volts of the breakdown voltage can be easily realized without being limited by channel region 109.

Specifically, the channel region 109 and the drift region 104 are respective independent, where respective independent is defined as:
1. the channel region 109 is formed by independent processes, and the drift region 104 is formed by independent processes; i.e., the channel region 109 and the drift region 104 are not formed by the same processes;
2. the channel region 109 is an independent structure from the drift region 104, the drift region 104 is an independent structure from the channel region 109, and the structures of the two do not interact with each other; and
3. the parameters of the channel region 109 can be separately controlled during the manufacturing process according to the requirements of the lateral SiC-JFET device, and the parameters of the drift region 104 can be separately controlled during the manufacturing process according to the requirements of the lateral SiC-JFET device. The parameters comprise but are not limited to, size, concentration, and the like.

As shown in Fig. 2, the base of the lateral SiC-JFET device comprises a N+ substrate, a P+ epitaxial layer 102, and a P- epitaxial layer 103.

The N+ substrate, as a mature product for mass production currently with high precision and low cost, is suitable for the development of lateral SiC-JFET devices.

In an alternative mode, the base of the lateral SiC-JFET device can further comprise a high-resistance SiC substrate, a P+ epitaxial layer 102, and a P- epitaxial layer 103. The lateral SiC-JFET device with the high-resistance SiC substrate, the P+ epitaxial layer 102 and the P- epitaxial layer 103 and the lateral SiC-JFET device with the N+ substrate, the P+ epitaxial layer 102 and the P-epitaxial layer 103 are consistent in other structure.

Although the current mass production rate of the high-resistance SiC substrate is not too high resulting in a slightly higher cost, the lateral SiC-JFET device with a high-resistance SiC substrate has an excellent performance, and it is an important direction for the development of lateral SiC-JFET device. As the cost of the high-resistance substrate decreases, there will be more and more lateral SiC-JFET devices with the high-resistance SiC substrate.

In the embodiment, a first gap between the source 107 and the drift region 104. A second gap between the gate 110 and the second source contact region 111 and between the gate 110 and the drift region 104, that is the second gap is surrounding the gate 110. A PN junction formed by the drift region 104 and the P- epitaxial layer 103, a PN junction formed by the drift region 104 and the source 107, and a PN junction formed by between the drift region 104 and the gate 110 are broken down in sequence.

The PN junction is formed between the drift region 104 and the P- epitaxial layer 103, the PN junction is formed between the drift region 104 and the source 107, and the PN junction is formed between the drift region 104 and the gate 110, i.e., three PN junction are formed. The sizes of the first gap and the second gap affect the breakdown voltage of the lateral SiC-JFET device.

If the PN junction formed by the drift region 104 and the gate 110 is broken down, the gate 110 is burned. Therefore, it is necessary to avoid the situation, that is, the PN junction formed by the drift region 104 and the gate 110 is the last to be broken down among the three PN junctions.

When the PN junction formed between the drift region 104 and the P- epitaxial layer 103 and the PN junction formed between the drift region 104 and the source 107 are broken down, the avalanche current generated will flow down from the drain port under the action of the electric field, and the drain port is directly grounded through the substrate, avoiding the situation of burning the gate 110 and the drain 106. The drain port conducting away current makes the device have high reliability and robustness.

As an example, when the breakdown voltage of the lateral SiC-JFET device of the embodiment of the present disclosure is 150V, the PN junction formed between drift region 104 and the P- epitaxial layer 103, the PN junction formed between the drift region 104 and the source 107, and the PN junction formed between the drift region 104 and the gate 110 are at a breakdown voltage in the order of 150V to 200V, 50V to 100V, and 20V to 30V, according to the current simulation results. The latter two PN junctions can be posteriorly broken down effectively and the first PN junction can be priorly to broken down, by adjusting the widths of the first gap and the second gap.

The breakdown voltage of the lateral SiC-JFET device of the embodiment of the present disclosure can be adjusted, if there is a greater industrial requirement, specifically by adjusting the size of the drift region 104. The breakdown voltage comprises but is not limited to 200V, 500V, or 1 000V.

In the embodiment, as shown in Fig. 2, the lateral SiC-JFET device further comprises:
an oxide layer 206;
a source contact metallic compound 201-1, disposed inside the oxide layer 206 and on the first source contact region 108 and the second source contact region 111;
a source contact through hole 203-1, disposed inside the oxide layer 206 and on the source contact metallic compound 201-1;
a source metal layer 204-1, disposed inside the oxide layer 206 and on the source contact through hole 203-1; and
a grounded back hole 205, connected to the source metal layer 204-1 and penetrating through to the bottom of the substrate 101 from top to bottom.

The bottom of the substrate 101 is grounded and connected to a heat dissipation structure.

A source port comprises the source 107, the first source contact region 108 and the second source contact region 111. Thus, the source port grounded and connected to the heat dissipation structure can be realized through the source contact metallic compound 201-1, the source contact through hole 203-1, the source metal layer 204-1, and the grounded back hole 205, which can quickly dissipate the heat generated at the source port. The lateral SiC-JFET device of the embodiment of the present disclosure is suitable for radio frequency applications.

In the embodiment, as shown in Fig. 2, the lateral SiC-JFET device further comprises:
a drain 106, disposed inside the drift region 104 and spaced from the gate 110;
a drain implant region 105 disposed below the drain 106;
a drain contact metallic compound 201-3 disposed inside the oxide layer 206 and on the drain 106;
a source contact through hole 203-3, disposed inside the oxide layer 206 and on the source contact metallic compound 201-3; and
a source metal layer 204-3, disposed inside the oxide layer 206 and on the source contact through hole 203-3.

A drain port comprises the drain implant region 105 and the drain 106. The drain port is connected through the drain contact metallic compound 201-3 and the drain metal layer 204-3.

In the embodiment, the lateral SiC-JFET device further comprises:
a drain contact metallic compound 201-2, disposed inside the oxide layer 206 and on the drain 110; and
a source contact through hole 203-2, disposed inside the oxide layer 206 and on the source contact metallic compound 201-2.

A gate port comprises the gate 110 and the gate contact metallic compound 201-2. The gate port is connected through the gate contact metallic compound 201-2 and the gate contact through hole 203-2.

In the embodiment, as shown in Fig. 2, the lateral SiC-JFET device further comprises:
a gate shielding plate 202, disposed inside the oxide layer 206 and between the gate 110 and the drain 106; and
a gate shielding plate contact through hole (not shown in the drawings), disposed inside the oxide layer 206 and on the gate shielding plate 202, and connecting to the source metal layer 204-1.

Thus, the gate shielding plate 202 is connected to the source 107. The gate shielding plate 202 can effectively isolate the drain 106 and the gate 110, can significantly reduce the reverse blocking capacitance of the device, can significantly reduce the parasitic capacitance between the drain 106 and the gate 110, and improve the performance of the lateral SiC-JFET device.

In the embodiment, as shown in Fig. 2, the gate shielding plate 202 comprises an L-shape gate shielding plate and a Z-shape gate shielding plate spaced apart from the gate 110 to the drain 106.

The shape and the position of the gate shielding plate 202 affect the breakdown voltage, parasitic capacitance, and reliability of the devices, and the specific shapes and positions can be adjusted according to the design parameters of the devices.

The doping concentration of the N+ substrate is very high, and the resistivity is very low correspondingly. On the one hand, the cost of the N+ substrate is low. On the other hand, the low resistivity of the N+ substrate can ensure that the resistance on the source grounded path of the devices is low, and devices have a better performance.

Specifically, the drain implant region is a step-type drain implant region.

Specifically, the first source contact region 108 is a P-type first source contact region 108, and the second source contact region 111 is a N-type second source contact region 111.

Specifically, in the embodiment of the present disclosure, each functional region is formed in the P- epitaxial layer 103 separately to realize the overall structure of the lateral SiC-JFET device, and the functional regions comprise the source 107, the first source contact region 108, the drain 106, the second source contact region 111, the drift region 109, the drift region 104, the drain implant region 105 and the gate 110.

All regions of the lateral SiC-JFET device are provided by implantation, avoiding complex processes such as trenching, which is simple and less costly.

The lateral SiC-JFET device of the embodiment of the present disclosure has been designed by simulation, and the simulated devices can easily achieve a breakdown voltage of tens to hundreds of volts. Under the same breakdown voltage, the conducting resistance is several times reduced than that of the silicon-based devices. Simulation data shows that the gate shielding plate 202 can reduce the reverse blocking capacitance of the device more than 10 times.

### Embodiment 2

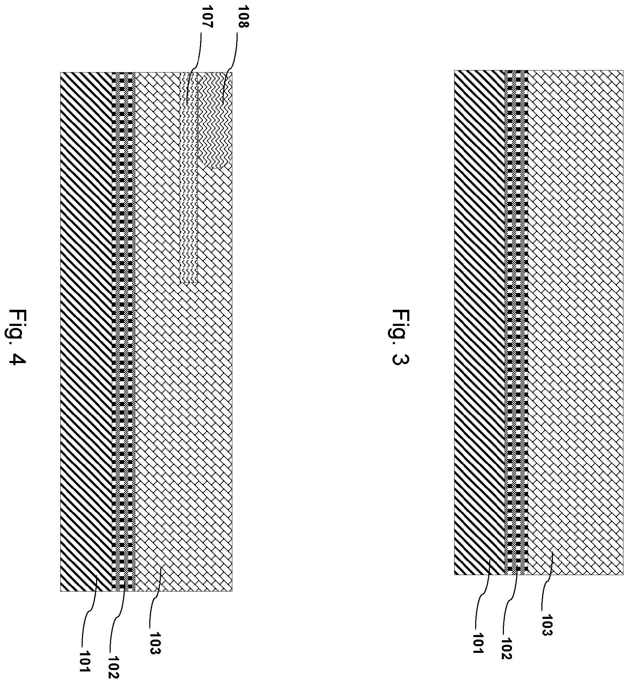

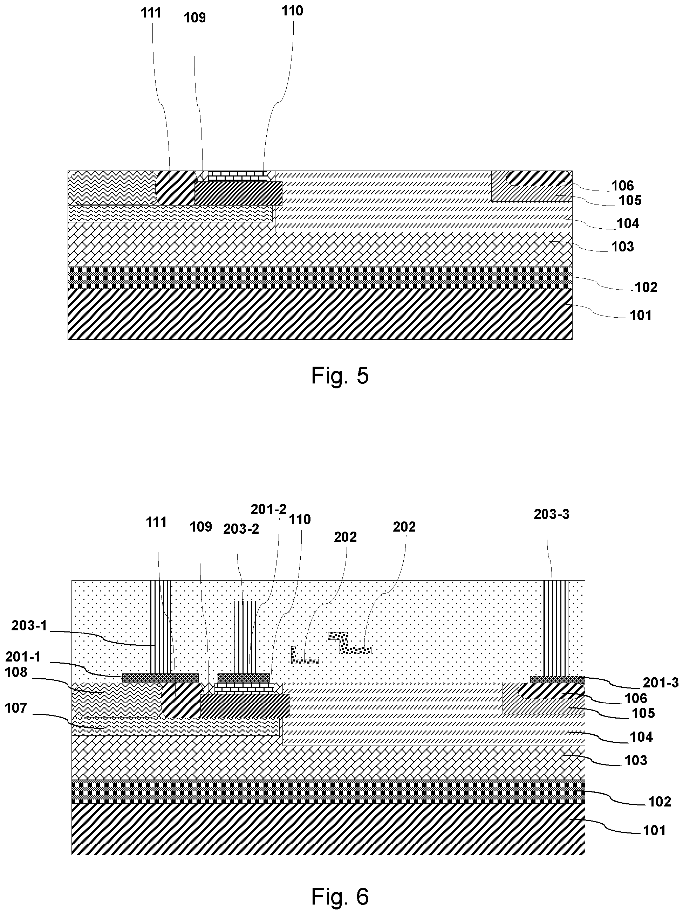

The manufacturing method of the lateral SiC-JFET device of the embodiments of the present disclosure for fabricating lateral SiC-JFET device according to Embodiment 1. The manufacturing method of the lateral SiC-JFET device comprises:
as shown in Fig. 3, Step S1, forming a P+ epitaxial layer 102 and a P- epitaxial layer 103 on the substrate 101 from bottom to top in sequence;
as shown in Fig. 4, Step S2, forming a source 107 and a first source contact region 108 inside P- epitaxial layer 103; and
as shown in Fig. 5, Step S3, forming a second source contact region 111, a channel region 109, a gate 110, and a drift region 104 by implanting.

The channel region 109 and the drift region 104 are respectively formed to be independent structures by respective independent implantation processes, so that the on-off characteristics of the lateral SiC-JFET device can be adjusted by the channel region 109 separately and the breakdown voltage of the lateral SiC-JFET device can be adjusted by the drift region 104 separately.

In the embodiment, a first gap is formed between the source 107 and the drift region 104; and
a second gap is formed between the gate 110 and the second source contact region 111, and between the gate 110 and the drift region 104.

In the embodiment, as shown in Fig. 6, the manufacturing method of the lateral SiC-JFET device further comprises Step S4:
forming a source contact metallic compound 201-1 on the first source contact region 108 and the second source contact region 111, a drain contact metallic compound 201-3 on the drain 106, and a gate contact metallic compound 201-2 on the gate 110;
growing a first layer of an oxide layer 206, fabricating the gate shielding plate 202, and growing a second layer of the oxide layer 206 to cover the gate shielding plate 202; and
punching holes to form a source contact through hole 203-1, a gate contact through hole 203-2, a drain contact through hole 203-3, and a gate shielding plate through hole.

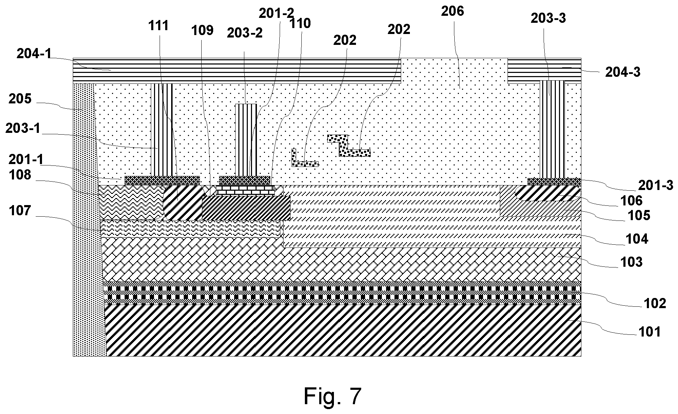

In the embodiment, as shown in Fig. 7, the manufacturing method of the lateral SiC-JFET device further comprises Step S5:
forming a source metal layer 204-1 and a drain metal layer 204-3; and
forming a grounded back hole 205.

The method is described in detail below as an example of manufacturing the lateral SiC-JFET device with the N+ substrate, and comprises the following steps:
As shown in Fig. 3, Step I, growing a P+ epitaxial layer 102 on the N+ substrate 101, and growing the P- epitaxial layer 103 on the P+ epitaxial layer 102.

The doping concentration of N+ substrate 101 is very high, correspondingly the resistivity is very low. On the one hand, the cost of the N+ substrate is low. On the other hand, the low resistivity of the N+ substrate can ensure that the resistance on the source grounded path of the devices is low, and devices have a better performance.

As shown in Fig. 4, Step II, applying glue on the P- epitaxial layer 103, exposing, developing, forming a photolithographic pattern, implanting the source 107, specifically the source 107 as a source buried layer, and finally removing the glue.

Similarly, the source contact region 108 is formed by similar steps. The first source contact region 108 is a very concentrated P-type region to ensure good electrode contact. The source buried layer is also a P-type region, but the implant concentration is lighter than the first source contact region 108. The first source contact region is connected to the source buried layer by adjusting the implantation dose.

As shown in Fig. 5, Step III, forming a drain 106, a second source contact region 111, a channel region 109, an n drift region 104, a drain 106 (specifically, a drain step implanting), and a gate 110 (specifically, a gate P region) by photoetching and implanting steps described above.

Although the names of the drain implant region 105 and the second source contact region 111 are different, they share the same lithography plate and are completed by the same implantation. a gap (i.e., the second gap) is left between the gate 111 and the second source contact region 111, and between the gate 111 and the N drift region 104, and adjusting the gap corresponds to adjusting the breakdown voltage of the device. a gap (i.e., the first gap) is further left between the source 107 and the n drift region 104, and adjusting the gap corresponds to adjusting the breakdown voltage of the device.

As shown in Fig. 6, Step IV, forming a second source contact metallic compound 201-1, a gate contact metallic compound 201-2, and a drain contact metallic compound 201-3 respectively on the second source contact region 111, the gate 110 and the drain 106;
growing the first oxide layer 206, fabricating the gate shielding plate 202, growing the first oxide layer 206 continuously, so as to seal the gate shielding plate 202, and grinding to planarize the oxide layer 206; and
punching holes to form a source contact through hole 203-1, a gate contact through hole 203-2, a drain contact through hole 203-3, and a gate shielding plate contact through hole, so as to lead out the three ports of the device.

The source contact metallic compound 201-1 is served as a contact electrode, the gate contact metallic compound 201-2 is served as a contact electrode, and the drain contact metallic compound 201-3 is served as a contact electrode. The source contact metallic compound 201-1 and the gate shielding plate 202 are connected together, that is, the gate shielding plate 202 is connected to the source 107.

The gate shielding plate 202 is disposed between the gate 110 and the drain 106, which can significantly reduce the parasitic capacitance between the drain 106 and the gate 110 and improve device performance.

As shown in Fig. 7, Step V, fabricating the metal layer on the planarized oxide layer 206, and leading out each port, forming a source metal layer 204-1 and a drain metal layer 204-3; and
fabricating the grounded back hole 205, so as to connect the source 107 of the device to the back of the wafer.

The device can have a structure of multiple oxide layers - contact through hole - metal layer for the convenience of plate design or other device design considerations, and correspondingly, the grounded back hole 205 can be connected to any layer of metal based on the different realization and other perspectives, and the source 107 is grounded.

### Embodiment3

The lateral SiC-JFET device of the embodiment of the present disclosure has the following differences from the lateral SiC-JFET device of Embodiment 1:
In the embodiments of the present disclosure, the base of the lateral SiC-JFET device is a high-resistance SiC substrate. Correspondingly, the PN junction formed between the drift region 104 and the source 107, and the PN junction formed between the drift region 104 and the gate 110 are broken down in sequence. In a case where two PN junctions are formed, the PN junction formed between the drift region 104 and the gate 110 remains broken down lastly.
In the descriptions of the disclosure and the embodiments thereof, it is to be understood that orientation or position relationships indicated by terms "top", "bottom", "height", and the like are orientation or position relationships shown in the drawings, are adopted not to indicate or imply that indicated devices or components must be in specific orientations or structured and operated in specific orientations but only to conveniently describe the disclosure and simplify descriptions, and thus should not be understood as limits to the disclosure.
In the disclosure and the embodiments thereof, unless otherwise definitely specified and limited, terms "arrange", "mount", "mutually connect", "connect", "fix" and the like should be broadly understood. For example, the terms may refer to fixed connection and may also refer to detachable connection or integration. The terms may refer to mechanical connection, may also refer to electrical connection, and may also refer to communication. The terms may refer to direct mutual connection, may also refer to indirect connection through a medium and may refer to communication in two components or an interaction relationship of the two components. One having ordinary skills in the art may understand specific meanings of the above terms in the embodiments of the present disclosure according to specific situations.
In the disclosure and the embodiments thereof, unless otherwise expressly stated and defined, the state that a first feature is "above" or "below" a second feature may include that the first feature directly contacts with the second feature, or may include that the first and second features contact not directly but through another feature therebetween. Moreover, the state that the first feature is "above", "over" and "on" the second feature may include that the first feature is over and above the second feature, or only represents that a horizontal height of the first feature is greater than that of the second feature. Moreover, the state that the first feature is "above", "over" and "on" the second feature may include that the first feature is over and above the second feature, or only represents that a horizontal height of the first feature is greater than that of the second feature.

The above disclosure provides many different implementation modes or examples to implement different structures of the disclosure. To simplify the disclosure of the disclosure, components and arrangements in specific examples are described above. Of course, they are merely examples and not intended to limit the disclosure. In addition, reference numbers and/or reference letters in the disclosure can be repeated in different examples, and such repetitions are for purposes of simplicity and clarity, and do not indicate relationships between the discussed implementation modes and/or arrangements. Moreover, the disclosure provides examples of various specific processes and materials, but those of ordinary skill in the art can realize disclosures of other processes and/or uses of other materials.

Although some optional embodiments of the disclosure have been described, one having ordinary skills in the art, once learning about basic creative concepts, may make other variations and modifications to these embodiments. Therefore, it is intended that the appended claims are explained to include the optional embodiments and all the variations and modifications falling within the scope of the disclosure.

It is apparent that one having ordinary skills in the art may make various modifications and transformations to the disclosure without departing from the spirit and scope of the disclosure. Therefore, if these modifications and transformations of the disclosure fall within the scope of the claims of the disclosure and equivalent technologies thereof, the disclosure is also intended to include these modifications and transformations.

## Claims

1. A lateral SiC-JFET device, **characterized in that**, comprising:
a base;
a source (107) and a drift region (104) formed on the base in sequence;
a first source contact region (108), a second source contact region (111), and a channel region (109) formed on the source in sequence; and
a gate (110), formed on the channel region;
wherein the channel region (109) and the drift region (104) are independent structures respectively.

2. The lateral SiC-JFET device according to claim 1, wherein the base comprises:
a substrate (101), being an N+ substrate or a high-resistance SiC substrate; and
a P+ epitaxial layer (102) and a P- epitaxial layer (103) disposed on the substrate (101) from top to bottom.

3. The lateral SiC-JFET device according to claim 2, wherein a first gap is formed between the source (107) and the drift region (104), a second gap is formed between the gate (110) and the second source contact region (111), and between the gate (110) and the drift region (104), so that a PN junction formed by the drift region (104) and the P- epitaxial layer (103), a PN junction formed by the drift region (104) and the source (107), and a PN junction formed by between the drift region (104) and the gate (110) are broken down in sequence.

4. The lateral SiC-JFET device according to claim 1, wherein the base is a high-resistance SiC substrate;
a first gap is formed between the source (107) and the drift region (104);
a second gap is formed between the gate (110) and the second source contact region (111), and between the gate (110) and the drift region (104); and
a PN junction formed by the drift region (104) and the source (107), a PN junction formed by the drift region (104) and a gate (110) are broken down in sequence.

5. The lateral SiC-JFET device according to claims 3 or 4, further comprising:
an oxide layer (206);
a source contact metallic compound (201-1), disposed inside the oxide layer (206) and on the first source contact region (108) and the second source contact region (111);
a source contact through hole (203-1), disposed inside the oxide layer (206) and on the source contact metallic compound (201-1);
a source metal layer (204-1), disposed inside the oxide layer (206) and on the source contact through hole (203-1); and
a grounded back hole (205), connected to the source metal layer (204-1) and penetrating through to a bottom of the base from top to bottom.

6. The lateral SiC-JFET device according to claim 5, further comprising:
a drain (106), disposed inside the drift region (104) and spaced from the gate (110);
a drain implant region (105) disposed below the drain (106);
a drain contact metallic compound (201-3) disposed inside the oxide layer (206) and on the drain (106);
a drain contact through hole (203-3), disposed inside the oxide layer (206) and on the drain contact metallic compound (201-3); and
a drain metal layer (204-3), disposed inside the oxide layer (206) and on the drain contact through hole (203-3).

7. The lateral SiC-JFET device according to claim 6, further comprising:
a gate contact metallic compound (201-2) disposed inside the oxide layer (206) and on the gate (110); and
a gate contact through hole (203-2), disposed inside the oxide layer (206) and on the gate contact metallic compound (201-2).

8. The lateral SiC-JFET device according to claim 7, further comprising:
a gate shielding plate (202), disposed inside the oxide layer (206) and between the gate (110) and the drain (106); and
a gate shield contact through hole, disposed inside the oxide layer (206) and on the gate shielding plate (202), and connected to the source metal layer (204-1);
wherein the gate shielding plate (202) comprises an L-shaped gate shielding plate and a Z-shaped gate shielding plate spaced apart from the gate (110) to the drain (106).

9. A manufacturing method of the lateral SiC-JFET device according to any one of claims 1 to 8, **characterized in that**, comprising:
forming (S1) a base;
forming (S2) a source (107) and a first source contact region (108) on the base; and
forming (S3) a second source contact region (111), a channel region (109), a gate (110), and a drift region (104) by implanting;
wherein the channel region (109) and the drift region (104) are respectively formed to be independent structures by respective independent implantation processes.

10. The manufacturing method of the lateral SiC-JFET device according to claim 9, wherein a first gap is formed between the source (107) and the drift region (104); and
a second gap is formed between the gate (110) and the second source contact region (111) and between the gate (110) and the drift region (104).

11. The manufacturing method of the lateral SiC-JFET device according to claim 10, further comprising:
forming a source contact metallic compound (201-1) on the first source contact region (108) and the second source contact region (111), a drain contact metallic compound (201-3) on the drain (106), and a gate contact metallic compound (201-2) on the gate (110);
growing a first layer of an oxide layer (206), fabricating the gate shielding plate (202), growing a second layer of the oxide layer (206) to cover the gate shielding plate (202); and
punching holes to form a source contact through hole (203-1), a gate contact through hole (203-2), a drain contact through hole (203-3), and a gate shielding plate through hole.

12. The manufacturing method of the lateral SiC-JFET device according to claim 11, further comprising:
forming a source metal layer (204-1) and a drain metal layer (204-3); and
forming a grounded back hole (205).
